# FASCICULE DE BREVET EUROPEEN

(11) **EP 3 794 415 B1**
(45) Date de publication et mention de la délivrance du brevet: **05.04.2023**
(21) Numéro de dépôt: 19708433.8
(22) Date de dépôt: 25.02.2019
(51) Int. Cl.: G05B 9/03, G01B 7/02, G01D 3/08, G01D 5/24

(54) **DISPOSITIF DE DETECTION CAPACITIVE REDONDANTE SERIE**
SERIENREDUNDANTE KAPAZITIVE ABTASTVORRICHTUNG
SERIES REDUNDANT CAPACITIVE SENSING DEVICE

(30) Priorité: 15.05.2018 FR 1854039
(43) Date de publication de la demande: 24.03.2021
(73) Titulaire: FOGALE SENSORS, 30900 Nimes (FR)
(72) Inventeur: NEEL, Christian, 30900 Nîmes (FR); ROZIERE, Didier, 30900 Nîmes (FR)
(74) Mandataire: IPAZ
(86) Numéro de dépôt international: PCT/EP2019/054608
(87) Numéro de publication internationale: WO 2019/219254

(56) Documents cités:
- US-A1- 2013 207 677
- US-A1- 2017 147 141
- US-B1- 6 370 960
- US-B2- 9 513 321

## Description

### Domaine technique

La présente invention concerne un dispositif détection capacitive redondante d'un objet. Elle concerne également une couche de détection munie d'un tel dispositif de détection et un équipement muni d'un tel dispositif ou d'une telle couche.

Le domaine de l'invention est, de manière non limitative, celui des interfaces de détection capacitive d'objets pour détecter les objets dans un environnement ou en contact avec une surface de détection.

### Etat de la technique

On connaît une première technique de détection capacitive basée sur la capacité mutuelle formée entre deux électrodes de mesure. On connaît aussi une deuxième technique de détection capacitive basée sur la capacité formée entre l'objet à détecter et une électrode de mesure. L'invention concerne cette deuxième technique de détection capacitive.

De manière générale, les dispositifs de détection capacitive peuvent être utilisés dans des domaines présentant des risques accrues ou critiques. C'est, par exemple, le cas des domaines où un opérateur côtoie un robot. Il est essentiel de s'assurer que le robot ne vient pas percuter l'opérateur, du fait d'un dysfonctionnement du dispositif de détection capacitive équipant le robot.

Cette exigence peut être satisfaite en prévoyant une détection capacitive redondante dans le dispositif de détection équipant le robot, tel que prévu dans le document US 9 513 321**.** Ce dernier prévoit d'utiliser, pour chaque emplacement/pixel de détection, deux paires d'électrodes, chaque paire d'électrodes réalisant une mesure indépendante de l'autre paire d'électrodes. Ainsi, lorsqu'une paire d'électrode subit un dysfonctionnement la détection est tout de même assurée par la paire restante.

Cependant, la solution décrite dans ce document est coûteuse et encombrante, car elle nécessite l'utilisation d'un nombre important d'électrodes. De plus, la solution proposée dans ce document est sensible aux perturbations mutuelles entre les paires d'électrodes et nécessite des moyens d'isolation des paires d'électrodes, ou une utilisation des paires d'électrodes à tour de rôle. Le document US 2017/147141 A1 décrit aussi l'utilisation d'un signal de détection pour chaque signal de mesure.

Un but de la présente invention est de remédier aux inconvénients précités.

Un autre but de la présente invention est de proposer un dispositif de détection capacitive redondante plus simple, moins coûteuse et moins encombrante.

Un autre but de la présente invention est de proposer un dispositif de détection capacitive redondante avec une sensibilité élevée permettant des détections d'objets à plus grande distance.

Encore un autre but de la présente invention est de proposer un dispositif détection capacitive limitant les composants électroniques utilisés pour la détection.

### Exposé de l'invention

Au moins un de ces buts est atteint avec un dispositif de détection capacitive d'un objet par rapport à une surface de détection, comprenant :
- au moins une électrode de détection capacitive, et
- une électronique de détection comprenant au moins une électronique, dite de mesure, pour :
   ▪ polariser ladite au moins une électrode de détection à un potentiel alternatif, dit d'excitation, différent d'un potentiel de masse, et
   ▪ mesurer un signal, dit de mesure, relatif à une capacité, dite électrode-objet, entre chaque électrode de détection et ledit objet ;
caractérisé en ce que l'électronique de détection comprend en outre, pour ladite au moins une électronique de mesure, au moins un premier et un deuxième modules de calcul distincts, fonctionnant en parallèle, et fournissant au moins deux signaux de détection indépendants pour un même signal de mesure issu de l'électronique de mesure.

Ainsi, le dispositif de détection selon l'invention permet d'obtenir, pour chaque emplacement de détection d'une surface de détection, des signaux de détection redondants par des modules de calcul indépendants montés en parallèle, avec une unique électronique de mesure, ce qui diminue le nombre, le coût et l'encombrement de l'électronique de détection utilisée, et donc dudit dispositif de détection.

De plus, pour chaque emplacement de détection d'une surface de détection, la détection capacitive peut être réalisée avec une unique électrode de mesure, ce qui est plus simple, moins coûteux et moins encombrant comparé aux dispositifs de l'état de la technique, et en particulier à celui décrit dans le document US 9 513 321. En outre, les signaux de détection redondants peuvent être obtenus simultanément.

Par ailleurs, la détection capacitive est basée sur la mesure d'un signal relatif à la capacité électrode-objet entre une électrode de détection et l'objet, ce qui permet de réaliser une détection avec une sensibilité élevée et à plus grande distance, en particulier comparé au dispositif du document US 9 513 321.

Dans la présente invention, le signal relatif à une capacité électrode-objet fourni par l'électronique mesure peut être, ou comprendre, par exemple, un signal relatif à ladite capacité, ou un inverse de ladite capacité, ou encore relatif à une distance et/ou un contact entre un objet et une électrode.

Dans la présente description, pour éviter des lourdeurs rédactionnelles, le terme « potentiel de masse » désigne un potentiel de référence de l'électronique, qui peut être par exemple une masse électrique ou un potentiel de masse. Ce potentiel de masse peut correspondre à un potentiel de terre, ou à un autre potentiel relié ou non au potentiel de terre.

Dans la présente demande, deux potentiels alternatifs sont identiques à une fréquence donnée lorsqu'ils comportent chacun une composante alternative identique à cette fréquence. Ainsi, l'un au moins des deux potentiels identiques à ladite fréquence peut comporter en outre une composante continue, et/ou une composante alternative de fréquence différente de ladite fréquence donnée.

De manière similaire, deux potentiels alternatifs sont différents à la fréquence de travail lorsqu'ils ne comportent pas de composante alternative identique à cette fréquence de travail.

Dans la présente invention, la résolution spatiale du dispositif de détection est déterminée par la dimension des emplacements de détection ou des électrodes de détection capacitives, et/ou leur espacement (par exemple de centre-à-centre).

L'électronique de mesure fournit un signal de mesure représentatif de la capacité électrode-objet. Le signal de mesure peut en particulier être une tension électrique, ou un signal numérique représentatif d'une tension électrique, mesuré par l'électronique de mesure.

Chacun des premier et deuxième modules de calcul peut alors fournir un signal de détection représentatif d'une distance ou une information de distance, et/ou un contact ou une information de contact, entre l'objet et ladite au moins une électrode de détection. Le signal de détection peut en particulier être ou comprendre l'un quelconque des signaux suivant, déduit à partir du signal de mesure fourni par l'électronique de mesure :
- un signal relatif à la capacité électrode-objet mesurée ;
- un signal relatif à la distance électrode-objet mesurée ;
- un signal relatif à un contact entre l'électrode et l'objet ;
- un signal relatif à une comparaison entre ladite capacité électrode-objet mesurée et une capacité seuil prédéterminée ;
- un signal relatif à une comparaison entre ladite distance électrode-objet mesurée et une distance seuil prédéterminée ; ou
- un signal d'alarme déduit en fonction de l'une desdites comparaison.

Le calcul de la distance, et/ou du contact, peut en particulier être réalisé en prenant en compte le signal de mesure fourni par l'électronique de mesure, ou en fonction d'une version numérisée dudit signal de mesure, ou d'un autre signal numérique ou analogique déduit dudit signal de mesure, par exemple par filtrage ou démodulation dudit signal de mesure à la fréquence de travail.

Chacun des premier et deuxième modules de calcul peut déterminer ledit signal de détection, ou par exemple ladite distance, ou ledit contact, par calcul ou par comparaison avec une table de référence préalablement établie.

Chacun des premier et deuxième modules de calcul peut également déterminer ledit signal de détection, ou par exemple ladite distance, ou ledit contact, directement en fonction d'une relation préalablement renseignée.

L'information de distance ou de contact peut par exemple également être, ou comprendre, une information de comparaison par rapport à un ou une pluralité de seuils de distance. Elle peut alors être utilisée par exemple pour déclencher des procédures de sécurité, tel que par exemple un ralentissement, ou un arrêt, ou une procédure de contournement, d'une machine ou un robot lorsqu'un obstacle ou un opérateur humain se trouve à une distance inférieure à un seuil.

Par ailleurs, chacun des premier et deuxième modules de calcul peut fournir un signal de détection comprenant une même information, mais déterminée de manière ou selon des procédés différents par chacun des module de calcul.

Suivant un mode de réalisation, le dispositif de détection selon l'invention peut en outre comprendre un troisième module de calcul, disposé entre l'au moins une électronique de mesure et lesdits premier et deuxième modules de calcul, et réalisant un traitement du signal de mesure fourni par ladite électronique de mesure.

Ce troisième module de calcul fournit un signal identique à chacun des premier et deuxième modules de calcul.

Ce troisième module de calcul peut réaliser un traitement du signal de mesure fourni par l'électronique de mesure. Ce traitement peut comprendre une mise en forme, une démodulation, etc. du signal mesuré par l'électronique de mesure.

Ce troisième module de calcul peut aussi réaliser une partie des calculs décrits plus haut pour déterminer les signaux de détection, à savoir, par exemple, un calcul de l'un quelconque des signaux suivant :
- un signal relatif à la capacité électrode-objet mesurée ;
- un signal relatif à la distance électrode-objet mesurée ;
- un signal relatif à un contact entre l'électrode et l'objet ;
- un signal relatif à une comparaison entre ladite capacité électrode-objet mesurée et une capacité seuil prédéterminée ; ou
- un signal relatif à une comparaison entre ladite distance électrode-objet mesurée et une distance seuil prédéterminée.

Chacun des premier, deuxième et troisième modules de calcul peut être, ou comprendre, tous types de circuits ou d'éléments électroniques, analogiques et/ou numériques. Ils peuvent par exemple être constitués, ou comprendre, un microprocesseur, une puce électronique, un FPGA, etc., ou même un simple élément de logique tel qu'un comparateur.

Avantageusement, l'électronique de détection peut comprendre en outre un module de contrôle agencé pour comparer les signaux de détection fournis par les premier et deuxième modules de calcul.

Ce module de contrôle a pour fonction de contrôler que les premier et deuxième modules de calcul fournissent un même résultat pour chaque électrode de détection. Si ce n'est pas le cas, alors il existe un dysfonctionnement dans le dispositif de détection.

Le module de contrôle peut donc fournir :
- un signal de comparaison des signaux fournis par les premier et deuxième modules de calcul, ou
- un signal d'alarme lorsque ladite comparaison constate une différence entre les signaux fournis par les premier et deuxième modules de calcul.

Le module de contrôle peut être un module électronique et/ou numérique distinct des autres modules.

Le module de contrôle peut être un microprocesseur, une puce électronique, une FPGA, etc.

Le module de contrôle peut alternativement être réalisé par des composants ou des fonctionnalités, implémentées dans l'un des, ou dans chacun des, premier et deuxième modules de calcul.

Ainsi, le module de contrôle peut être par exemple implémenté dans les premier et deuxième modules de calcul, sous la forme de deux sous-modules de contrôle indépendants. Chaque sous-module compare un signal issu du module de calcul dans lequel il est implanté avec le signal issu de l'autre module de calcul. Cet agencement permet une redondance et une sécurité de fonctionnement optimale puisque chaque module de calcul est surveillé par deux sous-modules de contrôle indépendants.

Le module de contrôle peut être agencé par exemple pour comparer les distances, ou les informations de distance, et/ou de contact, fournies par les premier et deuxième modules de calcul.

Le module de contrôle peut notamment déterminer des différences entre les signaux issus respectivement des modules de calcul et ainsi détecter des défaillances du dispositif de détection selon l'invention. Il peut alors être utilisée par exemple pour déclencher des procédures de sécurité, tel que par exemple un ralentissement ou un arrêt, en cas de détection d'une différence entre signaux supérieure (ou inférieure) à un seuil préétabli.

Suivant une version particulièrement avantageuse, l'électronique de détection peut comprendre au moins une capacité, dite de référence, utilisée pour vérifier et/ou calibrer le fonctionnement de l'au moins une électronique de mesure et/ou d'au moins un module de calcul.

Cette capacité de référence est mesurée par l'électronique de détection de la même manière qu'une capacité électrode-objet entre une électrode de détection et un objet.

Une telle capacité de référence permet de réaliser une calibration des différents éléments du dispositif selon l'invention car sa valeur est connue.

Surtout, une telle capacité de référence permet de détecter un dysfonctionnement qui peut intervenir au niveau de l'électronique de mesure, ou de chaque module de calcul.

Par exemple, si pour la capacité de référence, les premier et deuxième modules de calcul fournissent deux résultats identiques mais erronés, alors il est fort possible que l'électronique de mesure est défaillante. Par contre, si l'un des modules de calcul fournit un résultat erroné alors que l'autre fournit un résultat correct, cela signale une défaillance au niveau dudit autre module de calcul.

Une telle capacité de référence peut être formée par un condensateur de valeur prédéterminée. Alternativement, une telle capacité de référence peut être formée par un composant électronique simulant ladite capacité.

La mesure de la ou des capacités de référence peut être réalisée, lors d'une séquence, dite de vérification.

La séquence de vérification peut être réalisée :
- à chaque démarrage du dispositif de détection, et/ou
- avant et/ou après chaque mesure d'une électrode de détection au sein d'un ensemble d'électrodes de détection, et/ou
- avant et/ou après chaque séquence de mesure d'une pluralité d'électrodes de détection, et/ou
- sur requête, etc.

Plusieurs capacités de référence peuvent être utilisées, par exemple pour vérifier ou calibrer un gain et un offset de l'électronique de mesure, et/ou pour introduire une redondance dans la mesure de ces capacités de référence.

Le dispositif selon l'invention peut en outre comprendre au moins une électrode, dite de garde, pour garder au moins une électrode de détection, laquelle au moins une électrode de garde étant polarisée à un potentiel de garde alternatif identique ou sensiblement identique au potentiel d'excitation à au moins une fréquence de travail, au moins lors d'une mesure de signal de mesure relatif à une capacité électrode-objet.

Une telle électrode de garde peut être disposée par exemple en regard d'une face d'au moins une électrode de détection, ou à proximité de ladite au moins une électrode de détection. Elle permet de garder électriquement l'électrode de détection et ainsi d'augmenter la portée de détection et la précision de détection, en protégeant ladite électrode de détection des capacités de couplage parasites notamment.

La ou les électrodes de garde peuvent être :
- individuelles à chaque électrode de détection, éventuellement avec une ou plusieurs électrodes de garde par électrode de détection ; ou
- communes à une pluralité de, ou toutes les, électrodes de détection, éventuellement avec une ou plusieurs électrodes de garde par électrode de détection.

Suivant une caractéristique non-limitative, particulièrement avantageuse, le dispositif selon l'invention peut comprendre, pour au moins une électrode de détection, au moins une électrode, dite de test, agencée pour vérifier, lors d'une séquence de vérification, le fonctionnement de ladite électrode de détection en :
- polarisant ladite électrode de test et ladite électrode de détection à des potentiels électriques différents à au moins une fréquence de travail, et
- mesurant un signal relatif à la capacité, dite test, entre ladite électrode de test et ladite électrode de détection.

Ainsi, le dispositif de détection selon l'invention propose, en plus de la vérification du bon fonctionnement de l'électronique de mesure et des modules de calcul, la vérification du bon fonctionnement de chaque électrode de détection (ou d'au moins une partie des électrodes de détection).

Lorsqu'une électrode de détection est en défaillance, alors cette défaillance peut être détectée en fonction de la valeur de la capacité test entre ladite électrode de détection et l'électrode de test. Pour ce faire, le signal relatif à la capacité de test est utilisé pour réaliser une comparaison à une valeur prédéterminée correspondant à la dite capacité test.

La séquence de vérification associée à l'électrode de test, ou à un ensemble d'électrodes de test correspondant à des électrodes de détection, peut être celle décrite plus haut pour la capacité de référence. Dans ce cas, des mesures de capacité de référence et de capacité de test peuvent être réalisées au cours d'une même séquence de vérification.

Alternativement, la séquence de vérification associée à une ou des électrodes de test peut être distincte de la séquence de vérification associée à la capacité de test.

De manière générale, la séquence de vérification associée à une ou une pluralité d'électrodes de test peut être réalisée :
- à chaque démarrage du dispositif, pour tout ou partie des électrodes de test, et/ou
- avant et/ou après une mesure d'une électrode de détection au sein d'un ensemble d'électrodes de détection, au moins pour l'électrode de test correspondante, et/ou
- avant et/ou après chaque séquence de mesures d'une pluralité d'électrodes de détection, pour tout ou partie des électrodes de test, et/ou
- sur requête, etc.

Il est à noter que l'utilisation de capacités de référence et/ou d'électrodes de test et la réalisation de séquences de vérifications associées telles que décrites précédemment sont nécessaires pour satisfaire aux exigences de sécurité en mettant en oeuvre une électronique de mesure unique pour chaque électrode. Un effet, cela permet de vérifier le bon fonctionnement de cette électronique et des électrodes de détection, régulièrement ou même entre chaque mesure, pour s'assurer qu'aucune mesure erronée n'est transmise en cas de défaillance de ces éléments.

L'invention comprend par ailleurs au moins deux modules de calcul pour pouvoir fournir au moins deux signaux de détection distinctes avec les diagnostics de défaillance associés. Cette redondance au niveau des sorties est rendue nécessaire par la nécessité de se prémunir contre la défaillance des éléments de supervision de niveau les plus élevés.

L'invention réalise ainsi un compromis optimal entre les impératifs de sécurité et une nécessaire limitation des coûts et de l'encombrement liés à la duplication de modules. Elle permet également d'interroger toutes les électrodes de manière sécurisée et redondante pour exploiter au mieux la résolution spatiale fournie par ces électrodes.

Avantageusement, pour au moins une électrode de détection, au moins une électrode de test peut être formée par une électrode de garde, ou une partie d'une électrode de garde, associée à ladite électrode de détection.

Ainsi, il n'est pas nécessaire de prévoir une couche additionnelle d'électrodes pour réaliser les électrodes de test, ce qui diminue le coût, l'encombrement et la complexité du dispositif selon l'invention.

Le dispositif selon l'invention peut comprendre un moyen de modification de la polarisation de l'au moins une électrode de test, respectivement de l'au moins une électrode de détection, entre une séquence de mesure et une séquence de vérification, de sorte à polariser ladite au moins une électrode :
- lors d'une séquence de vérification : à un premier potentiel électrique différent du potentiel d'excitation à au moins une fréquence de travail, et
- lors d'une séquence de mesure : à un deuxième potentiel alternatif, identique ou sensiblement identique audit potentiel d'excitation à au moins une fréquence de travail, ou correspondant au audit potentiel d'excitation.

Autrement dit, l'électrode de test et l'électrode de détection sont polarisées à un même potentiel lors d'une séquence de mesure et à des potentiels différents lors d'une séquence de vérification.

Le deuxième potentiel peut être le potentiel de garde, en particulier lorsque l'électrode de test est constituée par une partie, ou la totalité, d'une électrode de garde.

Suivant un mode de réalisation particulier, le moyen de modification de la polarisation peut comprendre une source de tension ou un oscillateur.

Il peut également comprendre un commutateur électrique permettant de commuter la polarisation des électrodes de test et/ou des électrodes de mesure entre une séquence de vérification et une séquence de mesure.

Suivant des modes de réalisation, le dispositif selon l'invention peut comprendre un moyen de modification de la polarisation de l'au moins une électrode de test, par exemple sous la forme d'un commutateur électrique pu d'un oscillateur. Dans ce cas, la polarisation de l'au moins une électrode de détection peut rester inchangée entre une séquence de mesure et une séquence de vérification.

Suivant d'autres modes de réalisation, le dispositif selon l'invention peut comprendre un moyen de modification de la polarisation de l'au moins une électrode de détection, par exemple sous la forme d'un commutateur électrique ou d'un oscillateur. Cette modification de la polarisation peut être effectuée directement ou par l'intermédiaire de l'électronique de mesure. Dans ce cas, la polarisation de l'au moins une électrode de test (correspondant à une électrode de garde) peut rester inchangée entre une séquence de mesure et une séquence de vérification.

Dans un mode de réalisation, le premier potentiel peut être le potentiel de masse.

Dans un mode de réalisation, le premier potentiel peut être un potentiel identique au potentiel d'excitation, mais d'amplitude différente. Le premier potentiel peut ainsi être par exemple un potentiel de même fréquence et de même forme d'onde que le potentiel d'excitation, mais d'une amplitude inférieure, entre la masse (amplitude nulle) et l'amplitude du potentiel d'excitation.

L'électronique de mesure peut comprendre un moyen de scrutation pour interroger au moins une partie des électrodes de détection, séquentiellement.

Ainsi, l'architecture de l'électronique de détection est simplifiée.

Un tel moyen de scrutation peut comprendre un switch reliant l'électronique de détection, séquentiellement ou à tour de rôle, à chaque électrode de détection, ou à chaque groupe d'électrodes de détection.

Ce switch peut en outre être agencé de sorte à relier respectivement les électrodes de détection, soit à l'électronique de détection, soit au potentiel de garde. Ainsi, les électrodes de détection qui ne sont pas reliées à l'électronique de détection, et donc non mesurantes, se comportent comme des éléments de garde vis-à-vis des électrodes de détection mesurantes.

L'électronique de mesure peut également comprendre un moyen de scrutation ou un switch (identique ou différent) pour interroger les capacités de référence. Dans ce cas, comme précédemment, ce switch peut en outre être agencé de sorte à relier les électrodes de détection non mesurantes au potentiel de garde.

Par ailleurs, l'électronique de détection peut comprendre une pluralité d'électroniques de mesure, chacune étant agencée pour interroger une électrode de détection, ou une pluralité d'électrodes de détection par l'intermédiaire d'un moyen de scrutation, et le cas échéant une ou des capacités de référence.

Dans ce cas :
- chaque électronique de mesure est agencée pour interroger une ou des électrodes de détection distinctes ;
- chaque électronique de mesure est reliée, directement ou indirectement, à au moins un premier et un deuxième module de calculs distincts.

De manière générale, l'électronique de détection peut être numérique, ou analogique, ou encore une combinaison de moyens numériques et analogique.

Suivant un exemple de réalisation, l'au moins une électronique de mesure peut comprendre un amplificateur opérationnel (AO) ou un circuit réalisant un amplificateur opérationnel, fonctionnant en amplificateur de transimpédance ou de charge, dont :
- une première entrée, par exemple inverseuse, est reliée à une ou des électrodes de détection, directement ou par l'intermédiaire d'un moyen de scrutation ;
- une deuxième entrée, par exemple non inverseuse, est reliée à un oscillateur fournissant un signal d'excitation ;
- la sortie est rebouclée sur ladite première entrée par l'intermédiaire d'une impédance, et en particulier d'une capacité.

Dans cette configuration, la sortie de l'AO fournit une tension Vₛ dont l'amplitude est proportionnelle une capacité, à savoir :
- la capacité électrode-objet vue par une électrode de détection, lors d'une phase de mesure,
- la capacité de test vue par une électrode de détection lors d'une séquence de vérification utilisant une électrode test, et
- la capacité de référence lors d'une séquence de vérification utilisant la capacité de référence.

La sortie de l'amplificateur opérationnel peut être reliée, directement ou indirectement, à un module de mesure de la tension Vₛ, qui lui-même est relié à un ou plusieurs modules de calcul, tel que le ou les modules de calcul décrits plus haut.

Ce module de mesure de la tension Vₛ peut comprendre une démodulation, telle qu'une démodulation synchrone à une fréquence de travail du potentiel alternatif d'excitation, ou une détection d'amplitude.

L'électronique de détection, et en particulier la ou les électroniques de mesure, peut au moins en partie être référencée électriquement au potentiel alternatif d'excitation.

Ainsi, l'électronique de détection n'apporte pas de capacités parasites visibles par les électrodes de détection, ce qui augmente la précision de détection.

Le dispositif selon l'invention peut en outre comprendre un oscillateur fournissant le potentiel alternatif d'excitation, et le potentiel de garde le cas échéant.

Chaque électrode de détection réalise une détection capacitive pour un emplacement de détection de la surface de détection.

Au moins une, en particulier chaque, électrode de détection peut être formée par une unique électrode de mesure.

Suivant une caractéristique optionnelle avantageuse, au moins une, en particulier chaque, électrode de détection peut comprendre au moins une première et une deuxième électrodes, dites de mesure, indépendantes.

Ainsi, le dispositif selon l'invention permet de proposer une plus grande redondance de détection pour chaque emplacement de détection.

Chacune des électrodes de mesure d'une électrode de détection peut être interrogée séquentiellement, par une même électronique de mesure.

Les électrodes de mesure d'une électrode de détection peuvent aussi être interrogées en parallèle, par des électroniques de mesure distinctes.

En particulier, l'électronique de mesure peut être commune à toutes les électrodes de mesure d'une électrode de détection. Dans ce cas, l'électronique de mesure peut comprendre un moyen de scrutation reliant chacune des électrodes de mesure à l'électronique de mesure à tour de rôle.

Suivant un autre mode de mise en oeuvre, le dispositif selon l'invention peut comprendre une première électronique de mesure commune pour toutes ou parties des premières électrodes de mesure, et une deuxième électronique de mesure commune pour toutes ou partie des deuxièmes électrodes de mesure. Dans ce cas, le dispositif de détection comprend deux électroniques de mesure distinctes, l'une dédiée aux premières électrodes de mesure et l'autre dédiée aux deuxièmes électrodes de mesure.

Suivant des exemples de réalisation, pour au moins une électrode de détection :
- les première et deuxième électrodes de mesure peuvent être juxtaposées de manière non imbriquée, ou
- l'une des premières et deuxièmes électrodes de mesure peut être au moins partiellement imbriquée dans l'autre desdites électrodes de mesure ; ou
- les premières et deuxièmes électrodes de mesure peuvent être au moins partiellement imbriquées l'une dans l'autre.

La ou les électrodes de détection, et/ou de garde, et/ou de test, peuvent être réalisées en tout matériau conducteur. Elles peuvent en particulier être réalisées avec un dépôt ou une couche métallique. Elles peuvent être également réalisées avec des techniques de type tissage et/ou dépôt sur un support textile.

Alternativement, l'une au moins, en particulier chacune, des électrodes peut être réalisée en un matériau transparent, tel que de l' Oxyde d'Indium Etain (ou ITO).

Suivant encore un autre aspect de l'invention, il est proposé une couche de détection, pour un équipement, munie d'un dispositif de détection selon l'invention.

Le dispositif de détection selon l'invention, en particulier les électrodes de détection, peu(ven)t être intégré(es) dans la couche de détection.

La couche de détection peut être intégrée dans l'équipement.

Alternativement, la couche de détection peut être indépendante de l'équipement et rapportée sur cet équipement, de manière amovible ou démontable.

Suivant un mode de réalisation, la couche de détection selon l'invention peut comprendre, selon une face, une pluralité d'électrodes de détection. Ces électrodes de détection peuvent être réparties selon une disposition matricielle.

Suivant un autre mode de réalisation, la couche de détection selon l'invention peut comprendre :
- selon une face, au moins une électrode de détection, et
- selon une autre face, au moins une électrode de garde et/ou au moins une électrode de test.

La couche de détection peut comprendre un matériau diélectrique souple, tel qu'un substrat de circuit imprimé, supportant selon l'une ou les deux faces des électrodes sous la forme de dépôts ou de couches métalliques.

La couche de détection peut bien entendu comprendre des couches de protection ou d'habillage sur les électrodes de détection et/ou de garde et/ou de test.

La couche de détection peut se présenter sous la forme d'un élément d'habillage, rigide ou souple.

La couche de détection peut se présenter sous la forme d'un élément d'habillage ou d'une peau, ou d'un textile d'habillage.

La couche de détection peut aussi se présenter sous la forme d'une pièce ou d'un élément d'habillage de forme tubulaire, tel que par exemple une coque ou un capot.

Suivant un autre aspect de la même invention, il est proposé un équipement muni d'un dispositif de détection selon l'invention, ou d'une couche de détection selon l'invention.

L'équipement peut se présenter par exemple sous la forme d'un robot fixe ou mobile, de forme humanoïde ou autre, ou sous la forme d'un bras manipulateur robotisé, ou d'un bras de robot ou d'un segment de robot, ou encore d'un véhicule autonome (AGV).

Suivant des modes de réalisation, le dispositif de détection, respectivement la couche de détection, peut être intégré(e) dans un organe de l'équipement, tel qu'une coque ou un capot.

Alternativement, le dispositif de détection, respectivement la couche de détection, peut être indépendant d'un organe de l'équipement et être disposé dans/sur un organe dudit équipement de manière démontable ou amovible.

### Description des figures et modes de réalisation

D'autres avantages et caractéristiques apparaîtront à l'examen de la description détaillée d'exemples nullement limitatifs, et des dessins annexés sur lesquels :
- les FIGURES 1-5 sont des représentations schématiques de cinq exemples de réalisation non limitatifs d'un dispositif de détection capacitive selon l'invention ;
- les FIGURES 6a-6e sont des représentations schématiques d'exemples de réalisation d'une électrode de détection capacitive pouvant être mise en oeuvre dans un dispositif selon l'invention ; et
- la FIGURE 7 est une représentation schématique d'un exemple de réalisation d'un robot muni d'un dispositif de détection selon l'invention.

Il est bien entendu que les modes de réalisation qui seront décrits dans la suite ne sont nullement limitatifs. On pourra notamment imaginer des variantes de l'invention ne comprenant qu'une sélection de caractéristiques décrites par la suite isolées des autres caractéristiques décrites, si cette sélection de caractéristiques est suffisante pour conférer un avantage technique ou pour différencier l'invention par rapport à l'état de la technique antérieur. Cette sélection comprend au moins une caractéristique de préférence fonctionnelle sans détails structurels, ou avec seulement une partie des détails structurels si cette partie uniquement est suffisante pour conférer un avantage technique ou pour différencier l'invention par rapport à l'état de la technique antérieur.

En particulier toutes les variantes et tous les modes de réalisation décrits sont combinables entre eux si rien ne s'oppose à cette combinaison sur le plan technique.

Sur les figures, les éléments communs à plusieurs figures conservent la même référence.

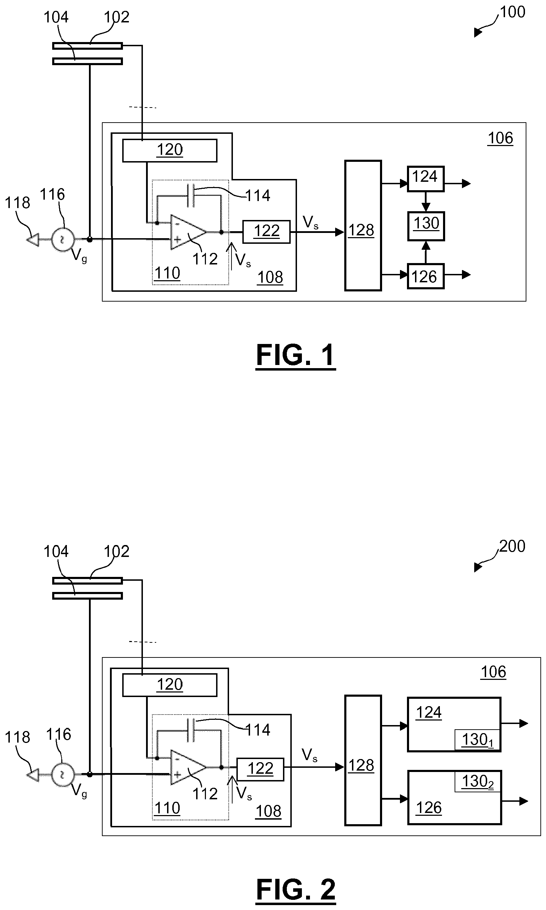

La FIGURE 1 est une représentation schématique d'un premier exemple de réalisation non limitatif d'un dispositif de détection capacitive selon l'invention.

Le dispositif de détection 100, représenté sur la FIGURE 1, peut être réalisée sous une forme analogique ou numérique, ou une combinaison analogique/numérique.

Le dispositif de détection 100 comprend plusieurs électrodes de détection capacitive 102, dont une seule est représentée sur la FIGURE 1 pour des raisons de clarté.

Le dispositif de détection 100 comprend aussi une ou plusieurs électrodes de garde 104, pour garder électriquement lesdites électrodes de détection 102. De même, une seule électrode de garde est représentée sur la FIGURE 1 pour des raisons de clarté.

Le dispositif 100 peut comprendre une seule électrode de garde 104 formant un plan de garde commun à plusieurs, ou à toutes les, électrodes de détection 102, ou une électrode de garde 104 individuelle pour chaque électrode de détection.

Le dispositif de détection 100 comprend en outre une électronique de détection 106. L'électronique de détection 106 comprend en particulier une électronique de mesure 108 reliée à l'électrode de détection 102 et à l'électronique de garde 104.

L'électronique de mesure 108 comprend un amplificateur de courant, ou de charge, 110 représenté par un amplificateur opérationnel (AO) 112 et une capacité de contre-réaction 114 rebouclant la sortie de l'AO 112 à l'entrée inverseuse « - » de l'AO 112.

Un oscillateur 116, référencé à un potentiel de masse 118, fournit une tension alternative d'excitation, notée V_{G}. Cette tension alternative d'excitation est également utilisée comme potentiel de garde pour polariser les électrodes de garde 104.

Dans l'exemple représenté, l'entrée non-inverseuse « + » de l'AO 112 reçoit la tension V_{G} et l'entrée inverseuse « - » de l'AO 112 est prévue pour être reliée à chaque électrode de détection 102 par l'intermédiaire d'un moyen de scrutation 120, qui peut être par exemple un switch, de sorte à interroger individuellement à tour de rôle un ensemble de « n » électrodes de détection. Le switch 120 est en outre agencé pour relier les électrodes de détection 102, soit à l'AO, soit au potentiel de garde.

Dans ces conditions, l'amplificateur de charge 110, et en particulier l'AO 112, fournit en sortie une tension V_{S} d'amplitude proportionnelle à la capacité de couplage Cₑₒ, dite capacité électrode-objet, entre l'électrode de détection 102 reliée à son entrée inverseuse « - » et un objet à proximité, ou en contact, de ladite électrode de détection 102.

L'électronique de mesure 108 peut en outre comprendre, de manière optionnelle, un conditionneur 122 permettant d'obtenir un signal représentatif de la capacité de couplage Cₑₒ recherchée. Ce conditionneur 122 peut comprendre, par exemple, un démodulateur synchrone pour démoduler le signal par rapport à une porteuse, à une fréquence de travail. Le conditionneur 122 peut également comprendre un démodulateur asynchrone ou un détecteur d'amplitude. Ce conditionneur 122 peut, bien entendu, être réalisé sous une forme analogique et/ou numérique (microprocesseur) et comprendre tous moyens nécessaires de filtrage, de conversion, de traitement, etc.

Le conditionneur 122 mesure et fournit la valeur de la tension V_{S}.

L'électronique de détection 106 comprend, pour l'électronique de mesure 108, au moins un premier module de calcul 124 et un deuxième module de calcul 126, distincts, fonctionnant en parallèle, et fournissant au moins deux signaux de détection indépendants pour un même signal de mesure issu de l'électronique de mesure 108.

Un troisième module de calcul 128, optionnel, peut être disposé entre l'électronique de mesure 108, et les premier et deuxième modules de calcul 124 et 126.

Chaque module de calcul 124-128 peut être réalisé par, ou comprendre, un microprocesseur, ou une puce électronique (FPGA), ou des éléments de logique (comparateurs ...) indépendant.

L'électronique de détection 106 comprend en outre un module de contrôle 130 agencé pour réaliser une comparaison des signaux fournis par les premier et deuxième modules de calcul 124 et 126, et vérifier le bon fonctionnement du dispositif de détection 100. Le module de contrôle 130 peut émettre un signal d'alarme ou un signal de sécurité en cas de défaillance du dispositif de détection 100.

Dans l'exemple représenté sur la FIGURE 1, le module de contrôle 130 peut être réalisé par un processeur, ou une puce électronique, indépendant.

Comme précisé plus haut, l'électronique de mesure 108 fournit en sortie une valeur de la tension Vₛ, ou une grandeur équivalente, sous forme numérique.

Suivant un premier exemple de réalisation, les premier, deuxième et troisième modules de calcul 124-128 peuvent être agencés pour réaliser les opérations suivantes :
- à partir du signal fourni par l'électronique de mesure 108, le troisième module de calcul 128 calcule, une valeur de distance entre un objet et l'électrode de détection 102, et fournit cette valeur de distance aux modules de calcul 124 et 126 ; et
- de manière indépendante, chaque module de calcul 124 et 126 compare cette distance à une valeur de distance seuil correspondant à une distance de sécurité ou un contact entre l'électrode de détection 102 et un objet, et fournit un signal relatif au franchissement de ladite distance de sécurité ou audit contact. Ce signal peut être un signal analogique, numérique, ou une fermeture ou une ouverture de relais.

Suivant un deuxième exemple réalisation, les premier, deuxième et troisième modules de calcul 124-128 peuvent être agencés pour réaliser les opérations suivantes :
- à partir du signal fourni par l'électronique de mesure 108, le troisième module de calcul 128 calcule, une valeur de capacité Cₑₒ entre un objet et l'électrode de détection 102, et fournit cette valeur de capacité aux modules de calcul 124 et 126 ; et
- de manière indépendante, chaque module de calcul 124 et 126 compare cette valeur de capacité à une valeur de capacité seuil correspondant à une distance de sécurité ou un contact entre l'électrode de détection et un objet, et fournit un signal relatif au franchissement de ladite distance de sécurité ou audit contact. Ce signal peut être un signal analogique, numérique, ou une fermeture ou une ouverture de relais.

Suivant un troisième exemple réalisation, les premier, deuxième et troisième modules de calcul 124-128 peuvent être agencés pour réaliser les opérations suivantes :
- à partir du signal fourni par l'électronique de mesure 108, le troisième module de calcul 128 calcule, une valeur de capacité entre un objet et l'électrode de détection 102, et fournit cette valeur de capacité aux modules de calcul 124 et 126 ; et
- de manière indépendante, chaque module de calcul 124 et 126 :
   ∘ calcule une valeur de distance à partir de la valeur de capacité fournie par le troisième module de calcul 128 ; et
   ∘ compare cette valeur de distance à une valeur de distance seuil correspondant à une distance de sécurité ou un contact entre l'électrode de détection 102 et un objet, et
   ∘ fournit un signal relatif au franchissement de ladite distance de sécurité ou audit contact. Ce signal peut être un signal analogique, numérique, ou une fermeture ou une ouverture de relais.

Suivant un autre exemple de réalisation, le dispositif de détection 100 peut ne pas comprendre de troisième module de calcul 128. Les premiers et deuxièmes modules de calcul 124-126 peuvent être agencés pour réaliser les opérations suivantes :
- à partir du signal fourni par l'électronique de mesure 108, de manière indépendante, chaque module de calcul 124 et 126 calcule une valeur de distance entre un objet et l'électrode de détection 102,
- compare cette distance à une valeur de distance seuil correspondant à une distance de sécurité ou un contact entre l'électrode de détection 102 et un objet, et
- fournit un signal relatif au franchissement de ladite distance de sécurité ou audit contact. Ce signal peut être un signal analogique, numérique, ou une fermeture ou une ouverture de relais.

L'électronique de détection 106, ou au moins sa partie sensible avec l'amplificateur de charge 110 peut être référencée (ou alimentée par des alimentations électriques référencées) au potentiel de garde V_{G}, pour minimiser les capacités parasites.

L'électronique de détection 106 peut également être référencée, de manière plus classique, au potentiel de masse 118.

La FIGURE 2 est une représentation schématique d'un deuxième exemple de réalisation non limitatif d'un dispositif de détection capacitive selon l'invention.

Le dispositif de détection 200, représenté sur la FIGURE 2, comprend tous les éléments du dispositif 100 de la FIGURE 1, sauf le module de contrôle 130.

A la différence du dispositif 100, dans le dispositif 200, le module de contrôle se présente sous la forme de deux sous-ensembles 130₁ et 130₂. Le sous-module 130₁ est intégré dans le premier module de calcul 124, et le sous-module 130₂ est intégré dans le deuxième module de calcul 126.

Chaque sous-module 130₁-130₂ communique avec l'autre sous-module 130₁-130₂ pour lui transmettre le signal calculé par le module de calcul 124-126 dans lequel il est intégré. Chaque sous-module 130₁-130₂ compare le signal issu du module de calcul 124-126 dans lequel il est implanté avec le signal issu de l'autre module de calcul 124-126. Les sous-module de contrôle 130₁-130₂ (ou le premier module de calcul 124 et/ou le deuxième module de calcul 126) peuvent émettre un signal d'alarme ou un signal de sécurité en cas de défaillance du dispositif de détection 100. Cet agencement permet une redondance et une sécurité de fonctionnement optimale puisque chaque module de calcul 124-126 est surveillé par deux sous-modules de contrôle indépendants 130₁-130₂.

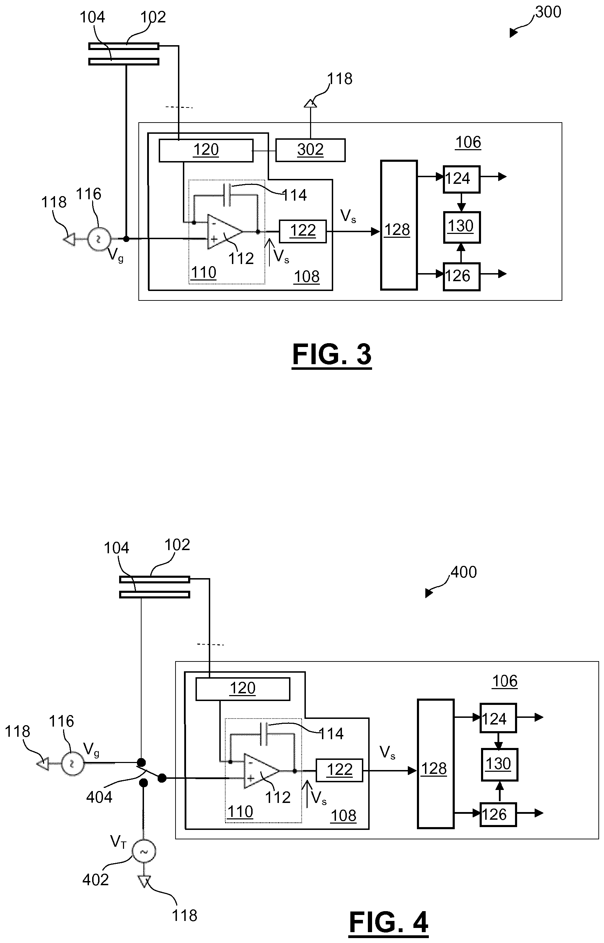

La FIGURE 3 est une représentation schématique d'un troisième exemple de réalisation non limitatif d'un dispositif de détection capacitive selon l'invention.

Le dispositif de détection 300, représenté sur la FIGURE 3, comprend tous les éléments du dispositif 100 de la FIGURE 1.

Le dispositif 300, et en particulier l'électronique de détection 106 du dispositif 300, comprend en plus une capacité de référence 302 qui est utilisée pour réaliser un calibrage ou une vérification du fonctionnement du dispositif de détection 300, lors d'une séquence de vérification.

La (ou les) capacité(s) de référence est (sont) reliée(s) à l'entrée inverseuse de l'amplificateur de charge 110 grâce au moyen de scrutation 120, pour réaliser la séquence de vérification. Dans ce cas, toutes les électrodes de détection 102 sont reliées au potentiel de garde. Si la valeur mesurée de la capacité de référence 302 est correcte alors aucune défaillance n'est à signaler. Dans le cas contraire, en particulier si la valeur mesurée de la capacité de référence 302 est hors d'une gamme de valeurs acceptables prédéfinies, le dispositif de détection 300 est défaillant et le module de contrôle 130 signale cette défaillance par un signal d'alarme ou un signal de sécurité. La valeur mesurée de la capacité de référence 302 peut également être utilisée, pour autant qu'elle soit dans la gamme de valeurs acceptables, pour effectuer une calibration de l'électronique de détection 106.

La séquence de vérification peut être réalisée avant ou après chaque séquence de mesure appliquée à un ensemble plusieurs électrodes de détection 102, ou avant ou après chaque mesure d'une électrode de détection 102.

Bien entendu, la capacité de référence 302, peut également être mise en oeuvre dans le dispositif 200 de la FIGURE 2.

La FIGURE 4 est une représentation schématique d'un quatrième exemple de réalisation non limitatif d'un dispositif de détection capacitive selon l'invention.

Le dispositif de détection 400, représenté sur la FIGURE 4, comprend tous les éléments du dispositif 100 de la FIGURE 1.

Le dispositif 400 comprend en outre un deuxième oscillateur 402, référencé au potentiel de masse 118 et fournissant un potentiel alternatif V_{T} identique au potentiel de garde V_{G} mais d'amplitude différent, en particulier d'amplitude plus faible.

Le dispositif 400 comprend en outre un commutateur électrique 404 permettant de commuter la polarisation de l'électrode de détection 102 de sorte que :
- dans une première position du commutateur 404, montrée en FIGURE 4, l'électrode de détection 102 est polarisée au potentiel V_{G}; et
- dans une deuxième position du commutateur 404, l'électrode de détection 102 est polarisée au potentiel V_{T}.

Le dispositif 400 permet d'utiliser l'électrode de garde 104 comme électrode de test et de mesurer la capacité, dite test, notée C_{T}, entre l'électrode de détection 102 et l'électrode de garde 104. La valeur de la capacité test C_{T} étant connue, il est possible de détecter une défaillance du dispositif de détection 400.

La capacité test C_{T} peut être mesurée lors d'une séquence de vérification pendant laquelle l'électrode de détection 102 est polarisée avec le potentiel V_{T} en basculant le commutateur 404 dans sa deuxième position.

La séquence de vérification peut être réalisée avant ou après chaque séquence de mesure appliquée à un ensemble plusieurs électrodes de détection 102, ou avant ou après chaque mesure d'une électrode de détection 102.

Suivant une alternative, le commutateur 404 peut être utilisé pour modifier la polarisation de l'électrode de garde 104, à la place de l'électrode de détection 102.

Suivant une autre alternative, le commutateur 404 peut être omis et remplacé par un deuxième oscillateur 402 qui fournit, soit le potentiel alternatif V_{T}, soit le potentiel d'excitation ou de garde V_{G}.

Bien entendu, le dispositif 400 peut également mettre en oeuvre la capacité de référence 302 du dispositif 300. Dans ce cas, la séquence de vérification peut réaliser une mesure à la fois des capacités test pour les électrodes de détection 102 et de la capacité de référence 302.

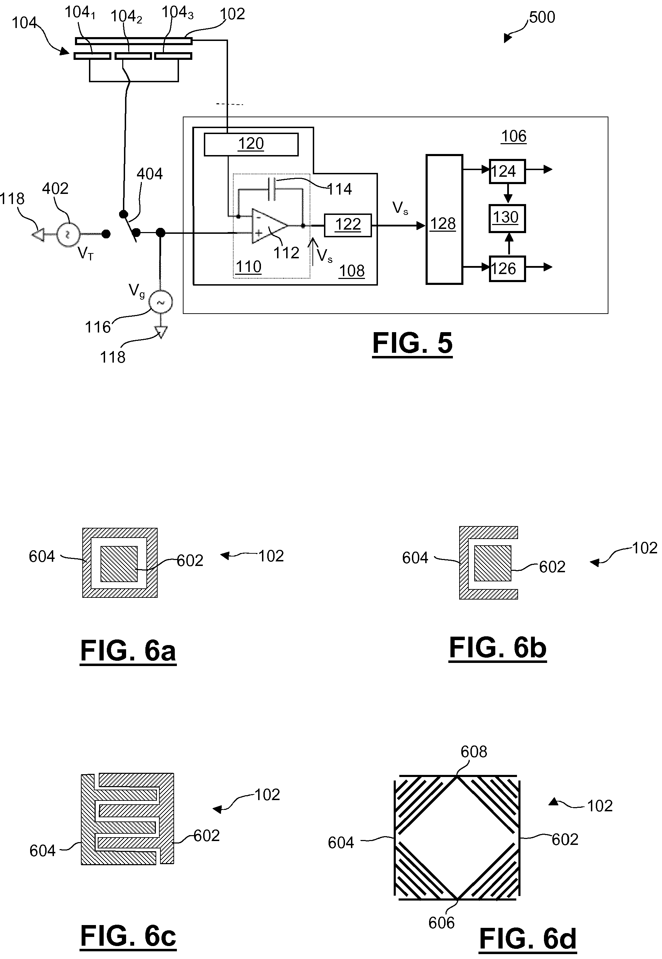

La FIGURE 5 est une représentation schématique d'un cinquième exemple de réalisation non limitatif d'un dispositif de détection capacitive selon l'invention.

Le dispositif de détection 500, représenté sur la FIGURE 5, comprend tous les éléments du dispositif 400 de la FIGURE 4.

Dans le dispositif 500, à la différence du dispositif 400, l'électrode de garde 104 est réalisée en trois parties indépendantes : 104₁-104₃.

Le commutateur 404 est utilisé pour modifier uniquement la polarisation de la partie 104₂ de l'électrode de garde 104. En particulier, le commutateur électrique 404 permet de commuter la polarisation de la partie 104₂ de l'électrode de garde 104 de sorte que :
- dans une première position du commutateur 404, montrée en FIGURE 5, la partie 104₂ de l'électrode de garde 104 est polarisée au potentiel V_{G}; et
- dans une deuxième position du commutateur 404, la partie 104₂ de l'électrode de garde 104 est polarisée au potentiel V_{T}.

Les autres parties 104₁ et 104₃ de l'électrode de garde 104 sont toujours polarisées au potentiel de garde V_{G}.

Le dispositif 400 permet d'utiliser, lors d'une séquence de vérification, la partie 104₂ de l'électrode de garde 104 comme électrode de test et de mesurer la capacité, dite test, notée C_{T}, entre l'électrode de détection 102 et la partie 104₂ de l'électrode de garde 104. La valeur de la capacité test C_{T} étant connue, il est possible de détecter une défaillance du dispositif de détection 500. Bien entendu :
- la partie 104₂ de l'électrode de garde 104 formant une électrode de test peut être propre à une électrode de détection 102, ou commune à plusieurs électrodes de détection 102 ;
- le dispositif 500 peut comprendre une ou une pluralité d'électrodes de test formées respectivement par une ou une pluralité de parties 104₂ d'électrode de garde 104.

La séquence de vérification peut être réalisée avant ou après chaque séquence de mesure appliquée à un ensemble plusieurs électrodes de détection 102, ou avant ou après chaque mesure d'une électrode de détection 102.

Suivant une alternative, le commutateur 404 peut être omis et remplacé par un deuxième oscillateur 402 qui fournit, soit le potentiel alternatif V_{T}, soit le potentiel d'excitation ou de garde V_{G}.

Bien entendu, le dispositif 400 peut également mettre en oeuvre la capacité de référence 302 du dispositif 300. Dans ce cas, la séquence de vérification peut réaliser une mesure à la fois des capacités test pour les électrodes de détection 102 et de la capacité de référence 302.

Chaque électrode de détection 102 peut être formée par une seule et unique électrode de mesure.

Alternativement, chaque électrode de détection 102 peut être réalisée par plusieurs, et en particulier deux, électrodes de mesure, pouvant être interrogées par l'électronique de détection 106 à tour de rôle ou séquentiellement. Ainsi, il est possible d'obtenir pour chaque emplacement de détection une détection redondante grâce à plusieurs électrodes de mesure.

Les FIGURES 6a-6e donnent cinq exemples de réalisation d'une électrode de détection pouvant être mise en oeuvre dans un dispositif de détection capacitive selon l'invention.

Sur la FIGURE 6a, l'électrode détection 102 est formée par une première électrode de mesure 602, imbriquée entièrement dans une deuxième électrode de mesure 604. La deuxième électrode de mesure 604 entoure totalement la première électrode de mesure 602. Les pistes de connexion peuvent alors être réalisées sur une autre couche de conducteur.

Sur la FIGURE 6b, l'électrode détection 102 est formée par une première électrode de mesure 602, imbriquée entièrement dans une deuxième électrode de mesure 604. La deuxième électrode de mesure 604 n'entoure pas totalement la première électrode de mesure 602, et se présente sous la forme d'un « C ».

Sur la FIGURE 6c, l'électrode détection 102 est formée par une première électrode de mesure 602 et une deuxième électrode de mesure 604 qui sont imbriquées l'une dans l'autre. Chaque électrode de mesure se présente sous la forme d'un peigne. Les peignes sont imbriqués l'un dans l'autre.

Sur la FIGURE 6d, l'électrode détection 102 est formée par quatre électrodes de mesure 602-608 qui sont imbriquées les unes dans les autres trois à trois. Les électrodes de mesure 602 et 604 sont identiques et se font face. Les électrodes de mesure 606 et 608 sont identiques et se font face.

Chaque électrode de mesure est imbriquée dans les deux électrodes de mesure qui lui sont adjacentes.

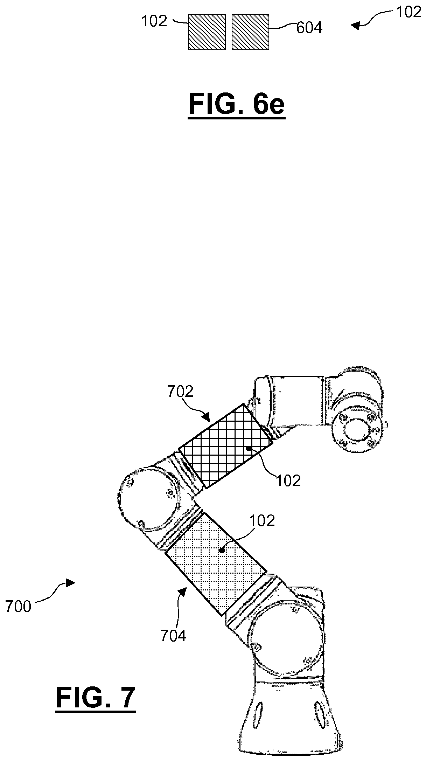

Sur la FIGURE 6e, l'électrode détection 102 est formée par une première électrode de mesure 602, juxtaposée avec une deuxième électrode de mesure 604.

La FIGURE 7 est une représentation schématique d'un robot équipé d'éléments d'habillage selon l'invention.

Le robot 700, représenté sur la FIGURE 7, est un bras robotisé comprenant plusieurs segments articulés, et reliés entre eux par des articulations rotatives.

Le robot 700 comporte deux éléments d'habillage 702 et 704 disposés sur deux segments du robot 700.

Chaque élément d'habillage 702-704 comprend un dispositif de détection selon l'invention, tel que par exemple l'un quelconque des dispositifs de détection des FIGURE 1-5.

Les électroniques de détection des dispositifs de détection équipant les éléments d'habillage 702 et 704 peuvent être distinctes, ou en partie ou en totalité, communes.

Les électrodes de détection 102 de chaque dispositif de détection équipant les éléments d'habillage 702-704 sont intégrées dans l'épaisseur dudit élément d'habillage, ou déposée sur une ou les faces dudit élément d'habillage 702-704.

Les éléments d'habillage 702-704 comprennent également une couche de garde pour éviter les couplages parasites entre les électrodes de détection et la structure du robot.

Les éléments d'habillage 702-704 sont utilisés soit à la place d'un élément d'habillage originel du robot, soit en plus d'un élément d'habillage originel.

Bien sûr, l'invention n'est pas limitée aux exemples qui viennent d'être décrits et de nombreux aménagements peuvent être apportés à ces exemples sans sortir du cadre de l'invention.

## Revendications

1. Dispositif de détection capacitive (100;200;300;400;500) d'un objet par rapport à une surface de détection, comprenant :
- au moins une électrode de détection capacitive (102), et
- une électronique de détection (106) comprenant au moins une électronique (108), dite de mesure, pour :
▪ polariser ladite au moins une électrode de détection (102) à un potentiel alternatif (V_{G}), dit d'excitation, différent d'un potentiel de masse (118), et
▪ mesurer un signal, dit de mesure, relatif à une capacité, dite électrode-objet, entre chaque électrode de détection (102) et ledit objet ;
**caractérisé en ce que** l'électronique de détection (106) comprend en outre, pour ladite au moins une électronique de mesure, au moins un premier et un deuxième modules de calcul (124,126) distincts, fonctionnant en parallèle, et fournissant au moins deux signaux de détection indépendants pour un même signal de mesure issu de l'électronique de mesure (108).

2. Dispositif (100;200;300;400;500) selon la revendication précédente, **caractérisé en ce que** l'électronique de détection (106) comprend en outre un module de contrôle (130;130₁,130₂) agencé pour comparer les signaux de détection fournis par les premier et deuxième modules de calcul (124,126).

3. Dispositif (300) selon l'une quelconque des revendications précédentes, **caractérisé en ce que** l'électronique de détection (106) comprend au moins une capacité (302), dite de référence, utilisée pour vérifier et/ou calibrer le fonctionnement de l'électronique de mesure (108) et/ou d'au moins un module de calcul (124-128).

4. Dispositif (100;200;300;400;500) selon l'une quelconque des revendications précédentes, **caractérisé en ce qu'**il comprend en outre au moins une électrode (104), dite de garde, pour garder au moins une électrode de détection (102), laquelle au moins une électrode de garde (104) étant polarisée à un potentiel de garde (V_{G}) alternatif identique, ou sensiblement identique, au potentiel d'excitation à au moins une fréquence de travail, au moins lors d'une mesure de signal de mesure relatif à une capacité électrode-objet.

5. Dispositif (400;500) selon l'une quelconque des revendications précédentes, **caractérisé en ce qu'**il comprend, pour au moins une électrode de détection (102), au moins une électrode (104;104₂), dite de test, agencée pour vérifier, lors d'une séquence de vérification, le fonctionnement de ladite électrode de détection (102) en :
- polarisant ladite électrode de test (104;104₂) et ladite électrode de détection (102) à des potentiels électriques différents à au moins une fréquence de travail, et
- mesurant un signal relatif à la capacité, dite test, entre ladite électrode de test (104;104₂) et ladite électrode de détection (102).

6. Dispositif (400;500) selon les revendications 4 et 5, **caractérisé en ce que**, pour au moins une électrode de détection (102), au moins une électrode de test (104;104₂) est formée par une électrode de garde (104), ou une partie (104₂) d'une électrode de garde (104), associée à ladite électrode de détection (102).

7. Dispositif (400;500) selon l'une quelconque des revendications 5 ou 6, **caractérisé en ce qu'**il comprend un moyen (402,404) de modification de la polarisation de l'au moins une électrode de test (104₂) respectivement de l'au moins une électrode de détection (102), entre une séquence de mesure et une séquence de vérification, de sorte à polariser ladite au moins une électrode (104₂;102) :
- lors d'une séquence de vérification : à un premier potentiel électrique (V_{T}) différent du potentiel d'excitation (V_{G}) à au moins une fréquence de travail, et
- lors d'une séquence de mesure : à un deuxième potentiel alternatif (V_{G}), identique ou sensiblement identique audit potentiel d'excitation à au moins une fréquence de travail, ou correspondant au audit potentiel d'excitation.

8. Dispositif (400;500) selon la revendication 7, **caractérisé en ce que** le premier potentiel peut être :
- le potentiel de masse (118), ou
- un potentiel (V_{T}) identique au potentiel d'excitation, mais d'amplitude différente.

9. Dispositif (100;200;300;400;500) selon l'une quelconque des revendications précédentes, **caractérisé en ce que** l'au moins une électronique de mesure (108) comprend un moyen de scrutation (120) pour interroger au moins une partie des électrodes de détection (102), séquentiellement.

10. Dispositif (100;200;300;400;500) selon l'une quelconque des revendications précédentes, **caractérisé en ce que** l'électronique de détection (106) est au moins en partie référencée électriquement au potentiel alternatif d'excitation (V_{G}).

11. Dispositif (100;200;300;400;500) selon l'une quelconque des revendications précédentes, **caractérisé en ce que** chaque électrode de détection (102) réalise une détection capacitive pour un emplacement de détection de la surface de détection, au moins une électrode de détection (102) comprenant au moins une première et une deuxième électrodes (602-608), dites de mesure, indépendantes.

12. Dispositif (100;200;300;400;500) selon la revendication précédente, **caractérisé en ce que**, pour au moins une électrode de détection (102) :
- les première et deuxième électrodes de mesure (602,604) sont juxtaposées de manière non imbriquée, ou
- l'une des premières et deuxièmes électrodes de mesure (602,604) est au moins partiellement imbriquée dans l'autre desdites électrodes de mesure ; ou
- les premières et deuxièmes électrodes (602,604) de mesure sont au moins partiellement imbriquées l'une dans l'autre.

13. Couche de détection, pour un équipement (700), munie d'un dispositif de détection (100;200;300;400;500) selon l'une quelconque des revendications précédentes.

14. Couche de détection selon la revendication 13, **caractérisée en ce qu'**elle comprend, selon une face, une pluralité d'électrodes de détection (102) réparties selon une disposition matricielle.

15. Couche de détection selon l'une quelconque des revendications 13 ou 14, **caractérisé en ce que** qu'elle comprend :
- selon une face, au moins une électrode de détection (102), et
- selon une autre face, au moins une électrode de garde (104) et/ou au moins une électrode de test (104;104₂).

16. Couche de détection selon l'une quelconque des revendications 13 à 15, **caractérisé en ce qu'**elle se présente sous la forme d'un élément d'habillage, rigide ou souple.

17. Equipement (700) muni d'un dispositif de détection (100;200;300;400;500) selon l'une quelconque des revendications 1 à 12, ou d'une couche de détection selon l'une quelconque des revendications 13 à 15.

18. Equipement (700) selon la revendication précédente, caractérisé qu'il s'agit d'un robot, d'un bras manipulateur robotisé ou d'un segment de robot.

## Patentansprüche

1. Vorrichtung zur kapazitiven Erfassung (100;200;300;400;500) eines Objekts in Bezug auf eine Erfassungsfläche, umfassend:
- mindestens eine kapazitive Sensorelektrode (102), und
- eine Erfassungselektronik (106), welche mindestens eine sogenannte Messelektronik (108) umfasst:
▪ zur Polarisation der mindestens einen Sensorelektrode (102) auf ein, sich von einem Massepotential (118) unterscheidendes Wechselpotential (V_{G}), ein sogenanntes Anregungspotential, und
▪ zur Messung eines sogenannten Messsignals in Bezug auf eine Kapazität, eine sogenannte Objektelektrode, zwischen jeder Sensorelektrode (102) und dem Objekt;
**dadurch gekennzeichnet, dass** die Erfassungselektronik (106) für die mindestens eine Messelektronik außerdem mindestens ein erstes Rechenmodul und ein zweites, sich vom ersten unterscheidendes Rechenmodul (124, 126) umfasst, welche parallel arbeiten und mindestens zwei unabhängige Erfassungssignale für ein gleiches Messsignal aus der Messelektronik (108) bereitstellen.

2. Vorrichtung (100;200;300;400;500) nach dem vorhergehenden Anspruch, **dadurch gekennzeichnet, dass** die Erfassungselektronik (106) außerdem ein Prüfmodul (130;130₁;130₂) umfasst, das derart eingerichtet ist, dass es die vom ersten Rechenmodul und vom zweiten Rechenmodul (124,126) bereitgestellten Erfassungssignale vergleicht.

3. Vorrichtung (300) nach einem der vorhergehenden Ansprüche, **dadurch gekennzeichnet, dass** die Erfassungselektronik (106) mindestens eine sogenannte Referenzkapazität (302) umfasst, die zur Überprüfung und/oder Kalibrierung der Funktion der Messelektronik (108) und/oder mindestens eines Rechenmoduls (124-128) eingesetzt wird.

4. Vorrichtung (100;200;300;400;500) nach einem der vorhergehenden Ansprüche, **dadurch gekennzeichnet, dass** sie außerdem mindestens eine sogenannte Schirmelektrode (104) zum Abschirmen mindestens einer Sensorelektrode (102), wobei die mindestens eine Schirmelektrode (104) auf ein wechselndes Schirmpotential (V_{G}) polarisiert ist, das bei mindestens einer Arbeitsfrequenz mit dem Anregungspotential identisch oder im Wesentlichen identisch ist, zumindest während einer Messung eines Messsignals bezüglich einer Objektelektrode-Kapazität.

5. Vorrichtung (400;500) nach einem der vorhergehenden Ansprüche, **dadurch gekennzeichnet, dass** sie für mindestens eine Sensorelektrode (102) mindestens eine sogenannte Testelektrode (104;104₂) umfasst, welche dazu eingerichtet ist, während einer Überprüfungssequenz die Funktion der Sensorelektrode (102) zu überprüfen, durch:
- Polarisieren der Testelektrode (104;104₂) und der Sensorelektrode (102) auf unterschiedliche elektrische Potentiale bei mindestens einer Arbeitsfrequenz, und
- durch Messung eines Signals, das sich auf die sogenannte Testkapazität zwischen der Testelektrode (104;104₂) und der Sensorelektrode (102) bezieht.

6. Vorrichtung (400;500) nach den vorhergehenden Ansprüchen 4 und 5, **dadurch gekennzeichnet, dass** für mindestens eine Sensorelektrode (102) mindestens eine Testelektrode (104;104₂) durch eine Schirmelektrode (104) oder einen Teil (104₂) einer Schirmelektrode (104) gebildet wird, die der Sensorelektrode (102) zugeordnet ist.

7. Vorrichtung (400;500) nach einem der Ansprüche 5 oder 6, **dadurch gekennzeichnet, dass** sie ein Mittel (402,404) zur Änderung der Polarisation der mindestens einen Testelektrode (104₂) bzw. der mindestens einen Sensorelektrode (102) zwischen einer Messsequenz und einer Überprüfungssequenz, sodass die mindestens eine Elektrode (104₂;102) polarisiert wird:
- während einer Überprüfungssequenz: auf ein erstes elektrisches Potential (V_{T}), das sich von dem Anregungspotential (V_{G}) bei mindestens einer Arbeitsfrequenz unterscheidet, und
- während einer Messsequenz: auf ein zweites wechselndes Potential (V_{G}), das bei mindestens einer Arbeitsfrequenz mit dem Anregungspotential identisch oder im Wesentlichen identisch ist oder dem Anregungspotential entspricht.

8. Vorrichtung (400;500) nach Anspruch 7, **dadurch gekennzeichnet, dass** das erste Potential
- das Massepotential (118) oder
- ein Potential (V_{T}) sein kann, das mit dem Anregungspotential identisch ist aber eine andere Amplitude hat.

9. Vorrichtung (100;200;300;400;500) nach einem der vorhergehenden Ansprüche, **dadurch gekennzeichnet, dass** die mindestens eine Messelektrode (108) ein Abfragemittel (120) zum sequentiellen Abfragen mindestens eines Teils der Sensorelektroden (102) umfasst.

10. Vorrichtung (100;200;300;400;500) nach einem der vorhergehenden Ansprüche, **dadurch gekennzeichnet, dass** die Sensorelektrode (106) mindestens teilweise elektrisch auf das Anregungswechselpotential (V_{G}) referenziert ist.

11. Vorrichtung (100;200;300;400;500) nach einem der vorhergehenden Ansprüche, **dadurch gekennzeichnet, dass** jede Sensorelektrode (102) eine kapazitive Erfassung jeweils für eine Erfassungsstelle der Erfassungsfläche ausführt, wobei mindestens eine Sensorelektrode (102) mindestens eine erste und eine zweite, sogenannte Messelektrode (602-608) umfasst, welche unabhängig voneinander sind.

12. Vorrichtung (100;200;300;400;500) nach dem vorhergehenden Anspruch, **dadurch gekennzeichnet, dass** für mindestens eine Sensorelektrode (102):
- die ersten und zweiten Messelektroden (602,604) nicht ineinander verkeilt nebeneinander angeordnet sind, oder
- eine der ersten und zweiten Messelektroden (602,604) zumindest teilweise in der anderen der Messelektroden verkeilt ist; oder
- die ersten und zweiten Messelektroden (602,604) zumindest teilweise ineinander verkeilt sind.

13. Erfassungsschicht für eine Ausrüstung (700) mit einer Erfassungsvorrichtung (100;200;300;400;500) nach einem der vorhergehenden Ansprüche.

14. Erfassungsschicht nach Anspruch 13, **dadurch gekennzeichnet, dass** sie entlang einer Seite eine Vielzahl von Sensorelektroden (102) umfasst, die in einer Matrixanordnung verteilt sind.

15. Erfassungsschicht nach einem der Ansprüche 13 oder 14, **dadurch gekennzeichnet, dass** sie umfasst:
- entlang einer Seite mindestens eine Sensorelektrode (102), und
- entlang einer anderen Seite mindestens eine Schirmelektrode (104) und/oder mindestens eine Testelektrode (104;104₂).

16. Erfassungsschicht nach einem der Ansprüche 13 bis 15, **dadurch gekennzeichnet, dass** sie als starres oder flexibles Verkleidungselement ausgebildet ist.

17. Ausrüstung (700) mit einer Erfassungsvorrichtung (100;200;300;400;500) nach einem der Ansprüche 1 bis 12 oder mit einer Erfassungsschicht nach einem der Ansprüche 13 bis 15.

18. Ausrüstung (700) nach dem vorhergehenden Anspruch, **dadurch gekennzeichnet, dass** es sich um einen Roboter, einen Industrieroboterarm oder einen Robotersegment handelt.

## Claims

1. **A** device for capacitive detection (100;200;300;400;500) of an object with respect to a detection surface, comprising:
- at least one capacitive detection electrode (102), and
- detection electronics (106) comprising at least one electronics(108), called measurement electronics, for:
▪ polarizing said at least one detection electrode (102) at an alternating potential (V_{G}), called excitation potential, different from a ground potential (118), and
▪ measuring a signal, called measurement signal, relative to a capacitance, called electrode-object capacitance, between each detection electrode (102) and said object;
**characterized in that** the detection electronics (106) also comprises, for said at least one measurement electronics, at least one first and one second separate calculation modules (124,126), operating in parallel, and supplying at least two independent detection signals for one and the same measurement signal originating from the measurement electronics (108).

2. The device (100;200;300;400;500) according to the preceding claim, **characterized in that** the detection electronics (106) also comprises a control module (130;130₁,130₂) arranged to compare the detection signals supplied by the first and second calculation modules (124,126).

3. The device (300) according to any one of the preceding claims, **characterized in that** the detection electronics (106) comprises at least one capacitance (302), called reference capacitance, used to verify and/or calibrate the operation of the measurement electronics (108) and/or of at least one calculation module (124-128).

4. The device (100;200;300;400;500) according to any one of the preceding claims, **characterized in that** it also comprises at least one electrode (104), called guard electrode, to guard at least one detection electrode (102), said at least one guard electrode (104) being polarized at an alternating guard potential (V_{G}) identical or substantially identical to the excitation potential at at least one working frequency, at least during measurement of a measurement signal relative to an electrode-object capacitance.

5. The device (400;500) according to any one of the preceding claims, **characterized in that** it comprises, for at least one detection electrode (102), at least one electrode (104;104₂), called test electrode, arranged to verify, during a verification sequence, the operation of said detection electrode (102) by:
- polarizing said test electrode (104;104₂) and said detection electrode (102) at electrical potentials different to at least one working frequency, and
- measuring a signal relative to the capacitance, called test capacitance, between said test electrode (104;104₂) and said detection electrode (102).

6. The device (400;500) according to claims 4 and 5, **characterized in that** for at least one detection electrode (102), at least one test electrode (104;104₂) is formed by a guard electrode (104), or a part (104₂) of a guard electrode (104), associated with said detection electrode (102).

7. The device (400;500) according to any one of claims 5 or 6, **characterized in that** it comprises a means (402,404) for modifying the polarization of the at least one test electrode (104₂), respectively of the at least one detection electrode (102), between a measurement sequence and a verification sequence, so as to polarize said at least one electrode (104₂;102):
- during a verification sequence: at a first electrical potential (V_{T}) different from the excitation potential (V_{G}) at at least one working frequency, and
- during a measurement sequence: at a second alternating potential (V_{G}), identical or substantially identical to said excitation potential at at least one working frequency, or corresponding to said excitation potential.

8. The device (400;500) according to claim 7, **characterized in that** the first potential can be:
- the ground potential (118), or
- a potential (V_{T}) identical to the excitation potential, but having a different amplitude.

9. The device (100;200;300;400;500) according to any one of the preceding claims, **characterized in that** the at least one measurement electronics (108) comprises a polling means (120) to poll at least a part of the detection electrodes (102), sequentially.

10. The device (100;200;300;400;500) according to any one of the preceding claims, **characterized in that** the detection electronics (106) is at least partially referenced electrically to the alternating excitation potential (V_{G}).

11. The device (100;200;300;400;500) according to any one of the preceding claims, **characterized in that** each detection electrode (102) carries out a capacitive detection for a detection location of the detection surface, at least one detection electrode (102) comprising at least one first and one second independent electrodes (602-608), called measurement electrodes.

12. The device (100;200;300;400;500) according to the preceding claim, **characterized in that**, for at least one detection electrode (102):
- the first and second measurement electrodes (602,604) are juxtaposed in a non-interleaved manner, or
- one from the first and second measurement electrodes (602,604) is at least partially interleaved with the other of said measurement electrodes; or
- the first and second measurement electrodes (602,604) can be at least partially interleaved with one another.

13. A detection layer, for an equipment (700), fitted with a detection device (100;200;300;400;500) according to any one of the preceding claims.

14. The detection layer according to claim 13, **characterized in that** it comprises, along a face, a plurality of detection electrodes (102) distributed according to a matrix arrangement.

15. The detection layer according to any one of claims 13 or 14, **characterized in that** it comprises:
- along a face, at least one detection electrode (102), and
- along another face, at least one guard electrode (104) and/or at least one test electrode (104;104₂).

16. The detection layer according to any one of claims 13 to 15, **characterized in that** it has the form of a rigid or resilient trim element.

17. An equipment (700) fitted with a detection device (100;200;300;400;500) according to any one of claims 1 to 12, or a detection layer according to any one of claims 13 to 15.

18. The equipment (700) according to the preceding claim, **characterized in that** it is a robot, a robotized handling arm or a robot segment.
